(19) **Europäisches Patentamt / European Patent Office / Office européen des brevets**

(11) **EP 1 604 384 B1**

(12) **EUROPÄISCHE PATENTSCHRIFT**

(45) Veröffentlichungstag und Bekanntmachung des Hinweises auf die Patenterteilung:
**18.03.2009 Patentblatt 2009/12**

(21) Anmeldenummer: **04701565.6**

(22) Anmeldetag: **13.01.2004**

(51) Int Cl.:
*H01L 21/00* (2006.01)

(86) Internationale Anmeldenummer:
**PCT/CH2004/000010**

(87) Internationale Veröffentlichungsnummer:
**WO 2004/064122 (29.07.2004 Gazette 2004/31)**

(54) **ANLAGE ZUR BEARBEITUNG EINES SUBSTRATS**

INSTALLATION FOR PROCESSING A SUBSTRATE

EQUIPEMENT POUR TRAITER UN SUBSTRAT

(84) Benannte Vertragsstaaten:
**AT BE BG CH CY CZ DE DK EE ES FI FR GB GR HU IE IT LI LU MC NL PT RO SE SI SK TR**

(30) Priorität: **13.01.2003 US 439745 P**

(43) Veröffentlichungstag der Anmeldung:
**14.12.2005 Patentblatt 2005/50**

(73) Patentinhaber: **OC Oerlikon Balzers AG**
**9496 Balzers (LI)**

(72) Erfinder: **WEICHART, Jürgen**
**FL-9496 Balzers (LI)**

(74) Vertreter: **Roshardt, Werner Alfred**
**Keller & Partner**
**Patentanwälte AG**
**Schmiedenplatz 5**
**Postfach**
**3000 Bern 7 (CH)**

(56) Entgegenhaltungen:

| | |
|---|---|
| **EP-A- 0 486 966** | **EP-A- 0 844 659** |
| **US-A- 5 460 684** | **US-A- 5 508 357** |
| **US-A- 5 708 557** | **US-A1- 2003 012 628** |
| **US-B1- 6 259 592** | **US-B1- 6 547 559** |

**Beschreibung**

**Technisches Gebiet**

Die Erfindung betrifft eine Anlage, insbesondere eine Vakuumprozessanlage, zur Bearbeitung eines Substrats, insbesondere eines Halbleiterwafers, mit mindestens einer Bearbeitungsstation, die eine Aufspannelektrode mit einer ebenen Aussenfläche umfasst. Die Erfindung betrifft ferner einen Rahmen für eine derartige Anlage zum Halten und/ oder Transportieren des Substrats und ein Verfahren zum Bearbeiten eines Substrats, insbesondere eines Halbleiterwafers, in einer Vakuumprozessanlage.

**Stand der Technik**

Halbleiterwafer für die Herstellung von integrierten Schaltkreisen werden üblicherweise in Vakuumprozessanlagen bearbeitet, welche eine oder mehrere Bearbeitungsstationen umfassen, in welchen der Wafer in einer Vakuumkammer z. B. mittels seinem CVD- (Chemical Vapor Deposition) oder PVD-Verfahren (Physical Vapor Deposition) beschichtet oder geätzt wird. Dabei ist wichtig, dass der Wafer in der Kammer während der Bearbeitung mechanisch stabil gehalten ist, und dass seine Temperatur kontrolliert wird, so dass insbesondere dem Wafer zugeführte Prozesswärme abgeführt werden kann. Ansonsten droht sich der Wafer stark aufzuheizen, was zur Beschädigung oder Zerstörung desselben führen kann.

Zur Steigerung der Produktivität werden zunehmend grössere Wafer eingesetzt, zum Teil solche mit einem Durchmesser von 300 mm, in Zukunft dürften noch grössere Durchmesser Verwendung finden. Aufgrund der grossen Fläche und der geringen Dicke dieser Substrate (typischerweise 0.8 mm oder weniger) ergeben sich zusätzliche mechanische Anforderungen sowohl an das Halten der Wafer während deren Bearbeitung als auch an den Transport der Wafer durch die Vakuumprozessanlage, denn bereits eine geringe Krafteinwirkung kann zu Schäden bzw. zur Zerstörung der Substrate führen. Zur Verbesserung der Temperaturkontrolle werden die Wafer zum Teil auf der Rückseite abgeschliffen, bis sie eine Dicke von 200 $\mu$m oder weniger aufweisen, teilweise gar bis zu einer Dicke von lediglich noch 50-75 $\mu$m. Anschliessend werden die dünngeschliffenen Wafer in einer Vakuumprozessanlage auf ihrer Rückseite metallisiert. Bei derartig dünnen Substraten sind die Anforderungen an das Halten und den Transport noch höher.

Gleichzeitig muss eine gute Abführung der z. B. bei Sputterprozessen auftretenden Prozesswärme sichergestellt sein, denn die dünnen Substrate mit ihrer geringen Wärmekapazität erreichen sonst sehr schnell Temperaturen von mehr als 150 °C, bei welchen bereits bestehende Schichtsysteme auf den Wafern beschädigt werden können. Schon bei geringerer Erwärmung besteht überdies die Gefahr, dass thermische Eigenspannungen in einer auf dem Substrat abgeschiedenen Schicht auftreten, welche beim Abkühlen zu einer Deformation derselben führen. Die Abführung der Prozesswärme ist in Vakuumkammern erschwert, weil der Wärmetransport primär durch Wärmestrahlung erfolgen muss.

Die US-Patente Nr. 4,680,061 und 4,743,570 (Varian) zeigen ein Verfahren zum Temperieren von Wafern in einer Vakuumkammer. Die Wafer sind entlang ihres Umfangs durch mehrere Clips in Öffnungen einer Tragscheibe gehalten. Zum Kühlen werden sie in eine Position angrenzend an eine ebene Oberfläche eines Kühlelements gebracht, wobei in einen schmalen Spalt zwischen dem Kühlelement und die Rückseite des Wafers Argon eingebracht wird, so dass der Wärmetransport vom Wafer zum Kühlelement durch Wärmeleitung in diesem Rückseitengas verstärkt wird.

Die US 6,477,787 B2 (Applied Materials) betrifft ein Verfahren zum Heizen und Kühlen von Substraten in derselben Kammer, so dass auf eine separate Kühlkammer verzichtet werden kann. Der Kühlmechanismus umfasst eine Kühlplatte, auf welche das Substrat durch einen Transportmechanismus, z. B. einen Transportring mit nach innen gerichteten Tragefingern oder mehreren Hebestiften, transportiert werden kann. Die Abkühlung kann durch Gasfluss zwischen der Kühlplatte und dem Substrat verbessert werden.

Die in diesen Schriften offenbarten mechanischen Transport- und Haltevorrichtungen sind allerdings für grossflächige Substrate mit einer geringen Dicke wenig geeignet, weil beim Halten eine ungleichmässige Verteilung der Kräfte auf den Wafer erfolgt und sich somit mechanische Spannungen ergeben. Der Druck des Rückseitengases und damit der Wärmedurchgang ist nach oben beschränkt, weil sich ab einem gewissen Gasdruck der umfangsseitig oder punktweise gehaltene Wafer zu verformen beginnt. Deswegen lässt sich keine für dünne Substrate effektive Kühlung erreichen.

Das US-Patent Nr. 5,880,924 (Applied Materials) beschreibt eine elektrostatische Aufspannvorrichtung (Chuck), welche ein schnelles Festhalten und Ablösen eines Substrats erlaubt, indem die Lade- und Entladezeiten des Chucks verkürzt werden. Dazu umfasst die Aufspannvorrichtung eine dielektrische Schicht, auf welche das Substrat aufgelegt wird, eine Ladeelektrode, die in die dielektrische Schicht eingebettet ist, und eine von der Ladeelektrode isoliert angeordnete Entladeelektrode, welche das Substrat an der Oberfläche der dielektrischen Schicht kontaktiert.

Das US-Patent Nr. 6,547,559 (Veeco Instruments) betrifft ein Verfahren und eine Vorrichtung zum Halten eines Halbleiterwafers in einer Vakuumkammer. Wärme wird durch eine Gaszirkulation zwischen dem Wafer und einem Chuck übertragen. Das Wafersubstrat wird auf einer Aufnahmeplatte positioniert, welche durch Druckfedern mit einer Kraft nach oben beaufschlagt ist. Anschliessend wird ein Klemmring von oben gegen die Kraft der Druckfedern auf den Wafer abgesenkt. Der Wafer erreicht schliesslich eine Position in einem geringen Abstand zum Grundkörper des Chucks. Zwischen dem Chuck und dem Wafer kann nun ein Rückseitengas mit einem Druck von bis zu 1 Torr (133 Pa) zugeführt werden.

Das US-Patent Nr. 5,460,684 (Tokyo Electron) offenbart ebenfalls eine Vorrichtung, in welcher ein Halbleiter-Wafer während eines Ätz- oder schichtbildenden Prozesses durch einen elektrostatischen Chuck gehalten wird. Der Chuck ist auf einem kühlbaren Grundkörper aufgebaut und umfasst zuunterst einen Suszeptor, welcher die untere RF-Elektrode bildet. Auf dem Suszeptor ist eine isolierende Schicht aufgebracht und darauf wiederum die Chuck-Elektrode und eine Widerstandsschicht. Auf diese Widerstandsschicht wird der Wafer abgelegt. Sie sorgt dafür, dass nach Ausschalten der Chuck-Elektrode keine Anziehungskraft mehr zwischen dem Chuck und dem Wafer herrscht, so dass der Wafer gefahrlos abgehoben werden kann. Es ist eine Gaszuleitung vorgesehen, um der Rückseite des Wafers W ein wärmeleitfähiges Gas (z. B. He) zuzuführen. Schliesslich sind drei vertikal bewegliche Stifte vorgesehen, damit der Wafer von der Oberfläche der Widerstandsschicht abgehoben werden kann.

Die Europäische Patentanmeldung Nr. 0 844 659 A2 (Applied Materials) zeigt einen durchstichsicheren elektrostatischen Chuck, welcher einen guten Wärmetransport zwischen dem Chuck und dem Substrat ermöglichen soll. Der Chuck umfasst eine oder mehrere Elektroden, welche von einer Isolatorschicht bedeckt sind. Die Isolatorschicht umfasst eine elastische und anpassungsfähige Schicht, welche sich dem Substrat anpassen kann, sowie eine harte, durchstich-sichere Schicht, welche unterhalb der elastischen Schicht angeordnet ist. Um die Temperatur des Substrats 35 zu regulieren, wird in die Zwischenräume in der Isolatorschicht ein geeignetes Fluid eingebracht.

Das US-Patent Nr. 6,259,592 B1 (Applied Materials) betrifft einen elektrostatischen Chuck mit einer Polyimidschicht. Eine Ausführungsform des Chucks ist auf einem Sockel aufgebaut und umfasst übereinander eine Polyimid-Schicht, welche gleichzeitig als Klebeschicht und als Isolator dient, eine Elektrodenschicht und eine Auflageschicht, welche durch eine dotierte Polyimidpaste gebildet wird. Das Dotieren der obersten Schicht führt zu einer erhöhten Leitfähigkeit, so dass ein Johnsen-Rahbek-Effekt bewirkt und damit eine grössere Anpresskraft erreicht wird. Die Auflageschicht weist ausserdem Rillen auf, welche die Zirkulation eines Rückseitengases zur Temperierung des Chucks ermöglichen.

Das US-Patent Nr. 5,708,557 (Packard Hughes Interconnect) betrifft einen elektrostatischen Chuck, welcher als Auflage für einen Silizium-Wafer innerhalb einer Vakuumkammer auf einem Sockel angeordnet ist. Eine spulenförmige RF-Elektrode umgibt einen unteren Teil der Vakuumkammer. Der elektrostatische Chuck selbst umfasst einen Grundkörper, welcher als untere Elektrode dient und mit einer Stromquelle verbunden ist. Der Grundkörper wird z. B. durch eine zolldicke AluminiumSchicht gebildet. Die obere, geerdete Abschlusswand der Vakuumkammer dient als ' zweite Elektrode. Ein Rückseitengas kann dank einer Durchführung im Grundkörper und im oberen Teil des Chucks der Rückseite des Wafers zugeführt werden.

Die Europäische Patentanmeldung Nr. 0 486 966 A1 (Tokyo Electron) offenbart einen elektrostatischen Chuck mit einem Grundkörper, auf welchem übereinander eine erste und eine zweite isolierende Schicht angeordnet sind. Zwischen den isolierenden Schichten sind eine Haftschicht und die Chuck-Elektrode vorgesehen. Der Chuck zeichnet sich dadurch aus, dass die obere (zweite) isolierende Schicht aus einem anorganischen Material (z. B. AIN, $Al_2O_3$, $SiO_2$, $TiBaO_3$ oder $Si_3N_4$) besteht und nicht aus beispielsweise Polyimid. Eine derartige Schicht sei robust und widerstandsfähig und könne zudem kostengünstig hergestellt werden.

Die US-Anmeldung Nr. 2003/0012628 A1 (Entegris) beschreibt einen stapelbaren Rahmenträger für Folienrahmen für Halbleiterwafer. Auf der Trägerfolie des Folienrahmens ist einseitig eine Klebeschicht aufgebracht; der auf der Trägerfolie aufgebrachte Wafer kann zerschnitten, mitsamt der Trägerfolie transportiert oder auf der Trägerfolie gelagert werden. Der Rahmenträger kann beispielsweise aus PETG (Polyethylen-Terephthalat-Glycol) bestehen. Das Material kann einen leitenden Bestandteil umfassen, z. B. Kohle, so dass statische Elektrizität abgeleitet werden kann.

Die US 6,238,160 B1 (Taiwan Semiconductor Manufacturing) beschreibt ein Verfahren zum Transportieren und elektrostatischen Aufspannen eines Halbleiterwafers in einer Bearbeitungskammer, wobei ein elektrostatischer Greifarm eingesetzt wird. Der Greifarm lädt den Wafer auf und hält ihn während dessen Transport durch elektrostatische Kräfte. Dies hat den Vorteil, dass der Wafer gleichzeitig teilweise vorgeladen wird, so dass das Aufspannen auf den elektrostatischen Chuck vereinfacht ist und ein Gasplasma innerhalb der Kammer oder eine Ladeelektrode zum Kontaktieren des Wafers vermieden werden können. Ist der Wafer auf den Chuck aufgespannt, kann er temperiert werden, unterstützt durch ein Rückseitengas, z. B. Helium, welches in den Zwischenraum zwischen dem Wafer und dem Chuck eingebracht wird.

Durch die elektrostatische Aufspannvorrichtung (Chuck) wird das Halten des Substrats verbessert. Insbesondere ist auch ein höherer Druck des Rückseitengases möglich, ohne dass das Substrat verformt wird, wodurch eine bessere Ableitung von Prozesswärme erreicht werden kann.

Die bekannten Chucks sind allerdings aufwändig herzustellen und benötigen häufige Wartung, insbesondere muss die das Substrat kontaktierende Komponente regelmässig ausgewechselt werden. Kritisch ist auch der Vorgang des Ablösens des mechanisch empfindlichen Substrats von der Oberfläche der Aufspannvorrichtung. Dies erfolgt in der Regel mit beabstandeten Pins und kann bei unvollständiger Entladung des Chucks zur Beschädigung oder Zerstörung des Substrats führen.

**Darstellung der Erfindung**

Aufgabe der Erfindung ist es, eine dem eingangs genannten technischen Gebiet zugehörende Anlage zu schaffen, welche einen einfachen Aufbau aufweist, einfach gewartet werden kann, und in welcher ein dünnes und/oder grossflächiges, mechanisch empfindliches Substrat ohne Gefahr der Beschädigung oder Zerstörung bearbeitet werden kann.

Die Lösung der Aufgabe ist durch die Merkmale des Anspruchs 1 definiert. Gemäss der Erfindung umfasst die Anlage zum Halten und/oder Transportieren des Substrats mindestens einen Rahmen mit einem eingespannten Träger, wobei das Substrat ganzflächig auf dem Träger befestigbar ist. Der Träger besteht aus einem nicht-leitenden dielektrischen Material und ist einseitig mit einer leitfähigen Schicht versehen. Der Träger ist parallel und angrenzend an die Aussenfläche der Aufspannelektrode positionierbar, so dass die leitfähige Schicht des Trägers zusammen mit dem dielektrischen Material und der Aufspannelektrode eine elektrostatische Aufspannvorrichtung bildet. Dabei bilden die leitfähige Schicht und die Aufspannelektrode zwei Platten eines Plattenkondensators.

Durch die grossflächige Befestigung wird das Substrat sicher auf dem Träger gehalten und dadurch mechanisch stabilisiert, im Gegensatz zu einer Halterung, bei welcher das Substrat nur an dessen Rand oder an beabstandeten Punkten gehalten ist. Das Substrat kann zudem während der Bearbeitung auf dem Träger verbleiben, so dass auf aufwändige und schadenanfällige Einspann- oder Ablöseoperationen verzichtet werden kann und der Aufbau der Anlage vereinfacht wird. Das Substrat wird also bevorzugt vor der Bearbeitung auf dem Träger befestigt, verbleibt dort während der Transport- und Bearbeitungsoperationen und wird erst nach der erfolgten Bearbeitung, ausserhalb der Anlage, wieder vom Träger gelöst. Der Rahmen mit dem Träger wird regelmässig aus der Anlage heraus transportiert und kann somit einfach inspiziert und gegebenenfalls gewartet oder ausgetauscht werden.

Die Kombination der grossflächigen Befestigung auf dem Träger und dem grossflächigen Halten auf der elektrostatischen Aufspannelektrode der Aufspanneinrichtung (des Chucks) erlaubt eine mechanisch ausserordentlich stabile Unterstützung des Substrats und entsprechend auch eine gute Ableitung von Wärme. Bevorzugt entspricht die Ausdehnung der ebenen Aussenfläche mindestens einer Hauptfläche des Substrats. In gewissen Fällen kann die Nutzfläche des Substrats aber kleiner sein als die gesamte Substrat-Hauptfläche, z. B. wenn ein einzelnes viereckiges Halbleiterbauteil auf einem runden Wafer gefertigt wird. Dann kann die ebene Aussenfläche so gewählt werden, dass nicht das ganze Substrat, sondern nur die technisch bedingt verringerte Nutzfläche auf dem Chuck gehalten werden kann.

Die stabile Befestigung des Substrats auf einem in einem Rahmen eingespannten Träger ist auch bei Bearbeitungsstationen vorteilhaft, in welchen keine Kühlung notwendig ist.

Eine derartig durch die Elektrode und den im Rahmen eingespannten Träger gebildete elektrostatische Aufspanneinrichtung (Chuck) weist einen einfachen Aufbau auf. Dadurch, dass mit dem Träger ein Teil der elektrostatischen Aufspannvorrichtung regelmässig aus der Anlage transportiert wird, vereinfacht sich die Wartung derselben, indem dieser wartungsintensivste Teil routinemässig inspiziert und gegebenenfalls ausgetauscht werden kann. Der in der Anlage verbleibende Teil, nämlich die Aufspannelektrode, ist während der Bearbeitung des Substrats durch den vor ihr angeordneten Träger geschützt und weist deshalb einen geringen Wartungsaufwand auf.

Wird der Träger so angeordnet, dass die leitfähige Schicht von der Aufspannelektrode abgewandt ist, dass diese also das Substrat kontaktiert, erhöht das dielektrische Material des Trägers die Anzugskraft im Parallelplattenfeld.

Als Trägermaterial kann auch ein schwach dotiertes dielektrisches Material gewählt werden, welches halbleitende Eigenschaften aufweist. Dadurch ergibt sich anstelle der oben angegebenen Coulomb-Anziehung eine sog. Johnsen-Rahbek-Anziehung, welche aufgrund einer geringeren effektiven Plattendistanz deutlich stärker sein kann. Allerdings tritt die halbleitende Wirkung des dotierten dielektrischen Materials oft erst bei erhöhten Temperaturen auf, und es ist ein kontinuierlicher Ladestrom zum Ausgleich des auftretenden Leckstroms erforderlich, was den Aufbau der Vorrichtung aufwändiger macht.

Die Erfindung beschränkt sich nicht auf die Bearbeitung von Halbleiterwafern, sondern ist bei einer Vielzahl von insbesondere grossflächigen und/oder dünnen Werkstücken, z. B. auf Glas- oder Kunststoffbasis, anwendbar. Sie ist also insbesondere geeignet für die Verarbeitung von elektronischen Bauelementen, auch nach deren Vereinzelung, oder Solarzellen.

Das Substrat wird bevorzugt mittels eines vakuumtauglichen und lösbaren Klebers auf eine erste ebene Hauptfläche des Trägers aufgeklebt. Dadurch ist die grossflächige Befestigung am Träger sichergestellt. Bevorzugt weist der Kleber eine gute thermische Leitfähigkeit auf, so dass Wärme optimal abgeleitet wird.

Bevorzugt ist der Rahmen zumindest in einem Bereich leitfähig, und der Träger ist so im Rahmen eingespannt, dass die leitfähige Schicht den leitfähigen Bereich des Rahmens kontaktiert.

Der leitfähige Bereich des Rahmens und die Kontaktierung der leitfähigen Schicht des Trägers durch diesen Bereich ermöglicht einen einfachen Anschluss der zweiten Platte der Aufspannvorrichtung, indem lediglich eine Kontaktstelle am Rahmen kontaktiert werden muss.

Zum Ablösen des Substrats wird mit Vorteil die leitfähige Schicht des Trägers mit der Aufspannelektrode kurzgeschlossen. Unterstützt durch die Trägerfolie erlaubt dies ein sicheres Abheben des Substrats, bei welchem keine Gefahr einer Beschädigung besteht, weil keine lokalisierten Restkräfte vorhanden sind, welche auf das Substrat wirken können.

Vorzugsweise sind der Träger durch eine vakuumtaugliche, temperaturbeständige Folie und die leitfähige Schicht durch eine aufgedampfte Metallisierung oder ein leitfähiges Polymer gebildet. Als Material für die Folie eignet sich beispielsweise Polyimid. Eine derartige Folie ist preisgünstig; Wafer werden ausserdem beim Dünnschleifen zur mechanischen Stabilisierung zum Teil bereits auf Trägerfolien befestigt, und bei entsprechender Wahl des Folienmaterials lässt sich derselbe Träger auch für die anschliessende Beschichtung verwenden, ohne dass der Wafer an einer neuen Halteeinrichtung befestigt werden muss.

Alternativ lässt sich der Träger auch aus einem anderen nichtleitenden dielektrischen Material fertigen, z. B. aus einer Keramik oder Glas.

Mit Vorteil hat die Folie eine Dicke von 50-200 $\mu$m, vorzugsweise ungefähr 100 $\mu$m, und die Metallisierung eine Dicke von 0.03-0.5 $\mu$m, vorzugsweise ungefähr 0.1 $\mu$m. Eine derartige Foliendicke erlaubt eine hohe mechanische Stabilität und Dauerhaftigkeit der Folie. Gleichzeitig ist der Querschnitt des Trägers aber noch so gering, dass eine hohe anziehende Kraft möglich ist, wenn das Folienmaterial als Dielektrikum eingesetzt wird, und dass die Material- und Herstellungskosten tief gehalten werden können. Eine Metallisierung der angegebenen Dicke lässt sich kostengünstig realisieren und weist gute elektrische Eigenschaften für die Verwendung im erfindungsgemässen elektrostatischen Chuck auf, insbesondere wird aufgrund der hohen Leitfähigkeit einer solchen leitfähigen Schicht

Restladung, die nach dem Ausschalten des Chucks noch vorhanden ist, innert kurzer Zeit abgebaut.

Die Dicke der Folie bzw. der Metallisierung lassen sich selbstverständlich der jeweiligen Anwendung, d. h. insbesondere den Dimensionen des Substrats, den mechanischen Gegebenheiten oder den erwarteten Einwirkungen durch die Bearbeitung anpassen. In derselben Anlage können problemlos unterschiedliche Träger eingesetzt werden, z. B. auch solche aus einem Folienmaterial für gewisse Substrate und andere z. B. aus Glas für andere Substrate.

Soll bei der Bearbeitung des Substrats, z. B. beim Ätzen, Hochfrequenz eingesetzt werden, kann die Aufspannelektrode auf einem Grundkörper aufgebaut sein, welcher eine Hochfrequenz-Elektrode umfasst, wobei die Aufspannelektrode von der Hochfrequenz-Elektrode elektrisch isoliert ist. Die Aufspannelektrode wird vorzugsweise durch eine isolierte Durchführung durch die Hochfrequenz-Elektrode kontaktiert. Mit Vorteil ist dabei die elektrostatische Aufspanneinrichtung floatend, also weder mit der Hochfrequenzquelle noch mit dem Erdpotential verbunden. Dadurch lässt sich auf einfache Art und Weise auch eine Hochfrequenz-Spannung zur Bearbeitung des auf dem Träger befestigten und durch den Chuck gehaltenen Substrats einsetzen.

Im Fall, dass der Träger so vor der Aufspannelektrode angeordnet wird, dass die leitfähige Schicht der Aufspannelektrode zugewandt ist, wird ein Dielektrikum so vor der Aufspannelektrode angeordnet, dass es zwischen der Aufspannelektrode und dem Träger liegt. Durch die Wahl eines dünnen Dielektrikums mit einer hohen Dielektrizitätszahl er lässt sich - unabhängig vom Material des Trägers - eine hohe anziehende Kraft erreichen. Als Dielektrikum eignet sich insbesondere eine Platte aus Aluminiumoxid $Al_2O_3$ mit der hohen Dielektrizitätszahl $\varepsilon_r \approx 10$.

Alternativ lässt sich, wie bereits erwähnt, der Träger so vor der Aufspannelektrode anordnen, dass das Trägermaterial das Dielektrikum zwischen der Aufspannelektrode und der leitfähigen Schicht bildet. Dies erlaubt einen einfacheren und kostengünstigeren Aufbau der Anlage, führt allerdings aufgrund der typischerweise niedrigeren Dielektrizitätszahlen der wirtschaftlich verwendbaren Trägermaterialien zu geringeren Anzugskräften. Bei einer Vielzahl von Anwendungen reichen aber auch die derart erreichbaren Kräfte aus.

Mit Vorteil umfasst die Bearbeitungsstation eine Spannungsquelle zum Anlegen einer Spannung zwischen den Rahmen und die Aufspannelektrode, wobei insbesondere eine Gleichspannung von 200-1500-V, bevorzugt 500-1000 V, erzeugbar ist. Aufgrund der leitenden Verbindung zwischen dem Rahmen und der leitfähigen Schicht des Trägers kann so auf einfache Weise eine elektrostatische Aufspannvorrichtung gebildet werden, wobei weder eine direkte Kontaktierung des Substrats, noch ein Gasplasma zum Laden bzw. Entladen erforderlich ist. Die angegebenen Spannungen führen bei gebräuchlichen Trägerquerschnitten zu einem Anpressdruck, welcher für die Bearbeitung von Halbleiterwafern geeignet ist.

Die Aufspannelektrode kann mehrere Bereiche unterschiedlicher Polarität umfassen. Dadurch kann eine bi- oder multipolare elektrostatische Aufspannvorrichtung gebildet werden, bei welcher keine Gegenelektrode bzw. Gegenplatte benötigt wird. In diesem Fall kann also grundsätzlich auf die leitfähige Schicht des Trägers und die entsprechende elektrische Kontaktierung verzichtet werden. Generell sind aber mit bi- bzw. multipolaren Aufspannvorrichtungen geringere Anzugskräfte erreichbar als bei unipolarem Aufbau.

Vorzugsweise umfasst die Bearbeitungsstation eine Gaszuführung zum Zuführen eines Gases in einen Zwischenraum zwischen der Aufspannelektrode und dem Träger, wobei bevorzugt ein Gasdruck von mehr als 100 Pa erzeugbar ist. Dadurch wird eine effektive Wärmeableitung durch Wärmeleitung im Rückseitengas ermöglicht. Bei herkömmlich an ihrem Rand aufgespannten Substraten ist der erreichbare Gasdruck nach oben begrenzt, weil beim Überschreiten dieser oberen Grenze der rückseitige Gasdruck zu einer starken Durchbiegung des nur am Umfang eingespannten Substrats führt. Bei grossen und dünnen Halbleiterwafern ist beispielsweise ein Gasdruck von ca. 20 Pa erreichbar, was für eine effektive Kühlung nicht ausreicht. Die Lösung mit einem elektrostatischen Chuck und der grossflächigen Befestigung des Substrats auf einem Träger erlaubt einen bedeutend höheren Druck des Rückseitengases und damit eine wesentlich verbesserte Wärmeableitung vom Substrat.

Bei bestimmten Bearbeitungsschritten kann ein aufgespanntes Substrat auch geheizt werden, indem z. B. die ebene Aussenfläche der Aufspannelektrode entsprechend temperiert wird. Auch das Aufheizen kann durch ein Rückseitengas beschleunigt werden. Schliesslich gibt es Bearbeitungsschritte, bei welchen auf eine Temperierung des Substrats verzichtet werden kann. In diesen Fällen stellt die erfindungsgemässe Aufspannvorrichtung aber sicher, dass das Substrat stabil gehalten wird und nach erfolgter Bearbeitung einfach wieder von der Aufspannvorrichtung abgehoben werden kann.

Die erfindungsgemässe Anlage kann eine Mehrzahl von Bearbeitungsstationen umfassen sowie Mittel, z. B. Vakuumroboter, zum Transportieren des Rahmens mitsamt dem eingespannten Träger und dem Substrat von einer ersten Bearbeitungsstation zu einer zweiten Bearbeitungsstation. Der Aufbau einer solchen Anlage kann beispielsweise sternförmig sein, so dass vertikal ausgerichtete Rahmen entlang einer Kreisbahn bewegt werden, deren Achse parallel zu den Rahmenhauptflächen steht. Auch ein clusterartiger Aufbau mit horizontal angeordneten Rahmen ist möglich. Je nach Aufgabenstellung werden die Rahmen mit dem Substrat in den Bearbeitungsstationen abgelegt oder während des Prozessierens gehaltert. Die Bearbeitung respektive der Transport erfolgen entsprechend zeitgleich oder individuell. Dadurch, dass kein Plasma als Leiter bzw. Rückleiter erforderlich ist, lässt sich eine erfindungsgemässe Aufspannvorrichtung auch bei reinen Kühlstationen einsetzen, bei welchen kein Plasma aufgebaut wird. Derartige Kühlstationen können in einer Anlage zwischen zwei Stationen angeordnet werden, in denen eine weitergehende Bearbeitung des Substrats erfolgt.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:

Fig. 1    eine schematische Darstellung einer unipolaren Elektrode und eines Halte- und Transportrahmens einer ersten Ausführung einer erfindungsgemässen Bearbeitungsstation;

Fig. 2    eine schematische Darstellung einer unipolaren Elektrode und eines Halte- und Transportrahmens einer zweiten Ausführung einer erfindungsgemässen Bearbeitungsstation, bei welcher zwischen der Elektrode und dem im Rah- men eingespannten Träger ein Dielektrikum angeordnet ist;

Fig. 3    eine schematische Darstellung einer unipolaren Elektrode und eines Halte- und Transportrahmens einer dritten Ausführung einer erfindungsgemässen Bearbeitungsstation, welche eine Hochfrequenzquelle umfasst;

Fig. 4    eine schematische Darstellung einer bipolaren Elektrode und eines Halte- und Transportrahmens einer vierten Ausführung einer erfindungsgemässen Bearbeitungsstation; und

Fig. 5    eine schematische Darstellung einer Vakuumprozessanlage mit einer Mehr- zahl von Bearbeitungsstationen.

Grundsätzlich sind in den Figuren gleiche Teile mit gleichen Bezugszeichen versehen.

### Wege zur Ausführung der Erfindung

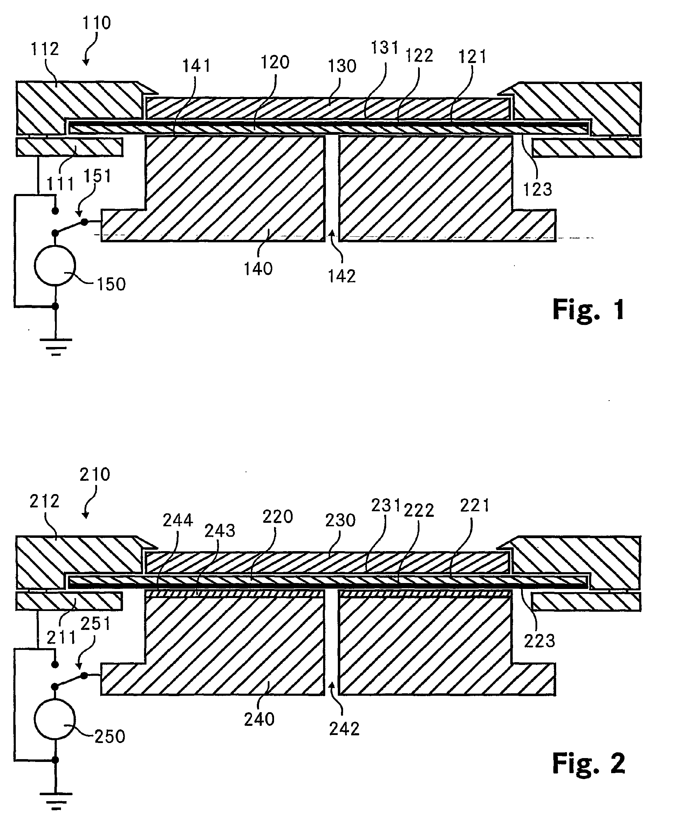

Die Figur 1 ist eine schematische Darstellung einer unipolaren Elektrode und eines Halte- und Transportrahmens einer ersten Ausführung einer erfindungsgemässen Bearbeitungsstation. Zugunsten einer besseren Sichtbarkeit entsprechen dabei die Längenverhältnisse der dargestellten Komponenten (wie auch bei den folgenden Figuren) nicht der Realität. In einem Rahmen 110 ist eine Trägerfolie 120 eingespannt, auf welcher ein grossflächiges und dünnes Substrat 130 befestigt ist. Das Substrat 130 ist beispielsweise ein kreisförmiger gedünnter Halbleiterwafer mit einem Durchmesser von 300 mm und einer Dicke von 200 $\mu$m.

Der Rahmen 110 ist so dimensioniert, dass das Substrat 130 ganzflächig auf der im Rahmen 110 eingespannten Trägerfolie 120 befestigt werden kann. Die Befestigung erfolgt zwischen der Unterseite 131 des Substrats 130 und der oberen Hauptfläche 121 der Trägerfolie 120 mittels eines vakuumtauglichen, vorteilhafterweise thermisch leitfähigen und später einfach wieder lösbaren Klebers. Der Rahmen 110 ist aus einem ringförmigen Unterteil 111 und einem damit lösbar verbundenen entsprechenden ringförmigen Oberteil 112 zusammengesetzt. Zwischen dem Unterteil 11 und dem Oberteil 112 ist die Trägerfolie 120 eingespannt. Die Einspannung kann durch reine Klemmwirkung erfolgen, zusätzlich oder anstelle davon kann die Trägerfolie 120 Öffnungen entlang ihres Umfangs aufweisen, durch welche entsprechende Stifte des Rahmens 110 hindurchgreifen.

Sowohl der Unterteil 111 als auch der Oberteil 112 des Rahmens 110 sind aus einem leitfähigen Metall hergestellt. Die Trägerfolie 120 ist aus Polyimid hergestellt und weist eine Dicke von 100 $\mu$m auf. Entlang ihrer oberen Hauptfläche 121 ist eine Metallisierung 122 mit einer Dicke von 0.1 $\mu$m aufgedampft, welche vom Oberteil 112 des Rahmens 110 elektrisch kontaktiert wird.

Der Rahmen 110 mit der eingespannten Trägerfolie 120 ist angrenzend an eine ebene obere Aussenfläche 141 einer metallischen Elektrode 140 angeordnet, wobei die untere Hauptfläche 123 der Trägerfolie 120 parallel und mit geringem Abstand zur oberen Aussenfläche 141 der Elektrode 140 positioniert ist. Die Positionierung des Rahmens 110 vor der Elektrode 140 geschieht mit Vorteil durch eine (nicht dargestellte) Führung für den Rahmen 110. Die Fläche und Form der oberen Aussenfläche 141 der Elektrode 140 entspricht im Wesentlichen der Form und Fläche des auf die Trägerfolie 120 aufgeklebten Substrats 130; dieselbe Elektrode 140 erlaubt aber auch das stabile Festhalten von Substraten geringerer oder grösserer Fläche.

Die Elektrode 140 weist im Bereich ihrer Symmetrieachse eine Gaszuführung 142 auf, durch welche ein Rückseitengas dem zwischen der Trägerfolie 120 und der Aussenfläche 141 der Elektrode 140 liegenden Zwischenraum zugeführt werden kann. Dazu ist an die Gaszuführung 142 eine (nicht dargestellte) an sich bekannte Gasquelle angeschlossen, welche das Gas, z. B. Argon, mit einem regelbaren Druck abgibt.

Zwischen der metallischen Elektrode 140 und dem mit der leitenden Metallisierung 122 elektrisch verbundenen Rahmen 110 ist eine Spannungsquelle 150 eingeschaltet, welche eine Gleichspannung von beispielsweise 700 V zwischen der Metallisierung 122 und der Aussenfläche 141 der Elektrode 140 erzeugt. Der Rahmen 110 und damit die Metallisierung 122 befinden sich dabei auf Erdpotential, während die Aussenfläche 141 auf einem Potential von 700 V gehalten wird. Dadurch ergibt sich eine anziehende elektrostatische Kraft zwischen der Metallisierung 122 der Trägerfolie 120 und der Aussenfläche 141 der Elektrode 140, und die Trägerfolie 120 mit dem darauf befestigten Substrat 130 wird an die Elektrode 140 gepresst. Die pro Fläche ausgeübte Kraft F/A ergibt sich gemäss der bekannten Formel

$$F/A = 1/2 \varepsilon_0 \varepsilon_r U^2 / d^2,$$

wobei U die angelegte Spannung und d die Dicke des Dielektrikums bedeuten. Bei der dargestellten Anordnung mit der Foliendicke d=100 $\mu$m, der Spannung U=700 V und einer Dielektrizitätszahl $\varepsilon_r$=2.5 der Trägerfolie 120 ergibt sich ein Anpressdruck p=F/A von ca. 540 Pa. Der Rückseitengasdruck darf den Anpressdruck des elektrostatischen Chucks nicht überschreiten, damit die Trägerfolie 120 mit dem Substrat 130 nicht durch den Gasdruck von der Elektrode 140 weg gedrückt wird. Im dargestellten Beispiel kann also z. B. ein Rückseitengasdruck von bis ca. 500 Pa gewählt werden, welcher einen sehr guten Wärmeübergang vom Substrat zum Chuck ermöglicht. Der k-Wert des Rückseitengases beträgt bei einem solchen Druck mindestens 50 W/m$^2$K. Für den Wärmeübergang ergibt sich folgende Situation:

| Schicht | Si-Wafer | Klebstoff | Folie | Rückseitengas |
|---|---|---|---|---|
| Wärmeleitfähigkeit [W/mK] | 150 | 0.1 | 0.2 | |
| Dicke [$\mu$m] | 200 | 20 | 100 | |
| k-Wert [W/m$^2$K] | $7.5 \times 10^5$ | $5 \times 10^3$ | $2 \times 10^3$ | 50 |
| % des Wärmewiderstands | $\approx 0$ | $\approx 1$ | $\approx 2$ | $\approx 97$ |

Im stationären Fall ergibt sich bei einer angenommenen Wärmebelastung von 0.3 W/cm$^2$ und einer Temperatur der Elektrodenoberfläche von 21°C eine Wafertemperatur von lediglich 83°C.

Im Vergleich dazu die Situation ohne Chuck, bei welcher das Rückseitengas lediglich einen Druck von 20 Pa annehmen kann, weil sich sonst eine zu starke Verbiegung des Substrats ergibt:

| Schicht | Si-Wafer | Klebstoff | Folie | Rückseitengas |
|---|---|---|---|---|
| Wärmeleitfähigkeit [W/mK] | 150 | 0.1 | 0.2 | |

(fortgesetzt)

| Schicht | Si-Wafer | Klebstoff | Folie | Rückseitengas |
|---|---|---|---|---|
| Dicke [$\mu$m] | 200 | 20 | 100 | |
| k-Wert [W/m$^2$K] | $7.5\times10^5$ | $5\times10^3$ | $2\times10^3$ | 10 |
| % des Wärmewiderstands | $\approx0$ | $\approx0$ | $\approx0$ | >99 |

Wegen des geringeren Gasdrucks beträgt der k-Wert des Rückseitengases höchstens 10 W/m$^2$K. Im stationären Fall ergibt sich bei derselben Wärmebelastung von 0.3 W/cm$^2$ und Temperatur der Kühleroberfläche von 21 °C eine Wafertemperatur von 323 °C. Diese führt zur Zerstörung von bereits vorhandenen Schichtstrukturen sowie zu thermischen Eigenspannungen in neu gebildeten Schichten, so dass das Substrat beschädigt oder zerstört wird.

Durch einen Schalter 151 kann der Rahmen 110 mit der Aussenfläche 141 kurzgeschlossen werden, so dass beide Bauteile auf Erdpotential gebracht werden. Danach lässt sich die Trägerfolie 120 mit dem Substrat 130 ungehindert von der Elektrode 140 lösen.

Die Figur 2 ist eine schematische Darstellung einer unipolaren Elektrode und eines Halte- und Transportrahmens einer zweiten Ausführung einer erfindungsgemässen Bearbeitungsstation, bei welcher zwischen der Elektrode und dem im Rahmen eingespannten Träger ein Dielektrikum angeordnet ist. Die zweite Ausführung entspricht in weiten Teilen der in der Figur 1 dargestellten ersten Ausführungsform.

In einem Rahmen 210 ist eine Trägerfolie 220 eingespannt, auf welcher ein grossflächiges und dünnes Substrat 230 befestigt ist. Das Substrat 230 ist wiederum mit seiner Unterseite 231 auf die obere Hauptfläche 221 der Trägerfolie 220 geklebt. Der Rahmen 210 entspricht dem Rahmen 110 der ersten Ausführung und ist aus einem ringförmigen Unterteil 211 und einem damit lösbar verbundenen entsprechenden ringförmigen Oberteil 212 zusammengesetzt, zwischen denen die Trägerfolie 120 eingespannt ist.

Ein erster Unterschied der zweiten Ausführungsform von der ersten Ausführungsform besteht nun darin, dass die Metallisierung 222 entlang der unteren Hauptfläche 223 der Trägerfolie 220 aufgedampft ist, d. h. die Trägerfolie 220 ist in umgekehrter Orientierung in den Rahmen 210 eingespannt. Die Metallisierung 222 wird vom Unterteil 211 des Rahmens kontaktiert, welcher wiederum aus einem leitfähigen Metall hergestellt ist.

Der Rahmen 210 mit der eingespannten Trägerfolie 220 ist angrenzend an eine dielektrische Platte 243 angeordnet, welche eine metallische Elektrode 240 nach oben abschliesst. Die dielektrische Platte 243 besteht aus Aluminiumoxid $Al_2O_3$, welches eine hohe Dielektrizitätszahl $\varepsilon_r\approx10$ aufweist; die Dicke beträgt ca. 100 $\mu$m. Die untere Hauptfläche 223 der Trägerfolie 220 mit der Metallisierung 222 ist parallel und mit geringem Abstand zur oberen Hauptfläche 244 der dielektrischen Platte 243 positioniert.

Die Fläche und Form der oberen Hauptfläche 244 der dielektrischen Platte 243 und damit der Elektrode 240 entspricht wiederum mindestens der Form und Fläche des auf die Trägerfolie 220 aufgeklebten Substrats 230. Die Elektrode 240 weist wiederum im Bereich ihrer Symmetrieachse eine Gaszuführung 242 auf, durch welche ein Rückseitengas dem zwischen der Trägerfolie 220 und der oberen Hauptfläche 244 der dielektrischen Platte 243 liegenden Zwischenraum zugeführt werden kann.

Eine Spannungsquelle 250 ist zwischen der metallischen Elektrode 140 und dem mit der leitenden Metallisierung 222 elektrisch verbundenen Rahmen 210 eingeschaltet, welche wiederum eine Gleichspannung von beispielsweise 700 V zwischen der Metallisierung 222 und der Elektrode 240 erzeugt, wobei sich der Rahmen 210 und damit die Metallisierung 222 wieder auf Erdpotential befinden, während die Elektrode 240 auf einem Potential von 700 V gehalten wird. Dadurch ergibt sich eine anziehende elektrostatische Kraft zwischen der Metallisierung 222 der Trägerfolie 220 und der Elektrode 140, so dass die Trägerfolie mit dem darauf befestigten Substrat 230 an die Elektrode 140 gepresst wird. Gegenüber der ersten Ausführungsform ist bei gleicher Dicke des Dielektrikums die pro Fläche ausgeübte Kraft F/A gemäss der oben erwähnten Formel aufgrund der höheren Dielektrizitätszahl $\varepsilon_r$ der dielektrischen Platte 243 ungefähr um den Faktor 3 erhöht. Es ergibt sich also bei gleicher Spannung ein Anpressdruck von ca. 1600 Pa, so dass der Rückseitengasdruck bedarfsweise erhöht werden kann, um, die Temperierung des Substrats weiter zu verbessern.

Durch einen Schalter 251 kann der Rahmen 210 wiederum mit der Elektrode 240 kurzgeschlossen werden, so dass beide Bauteile auf Erdpotential gebracht werden und die Trägerfolie 220 mit dem Substrat 230 von der Elektrode 140 abgehoben werden kann.

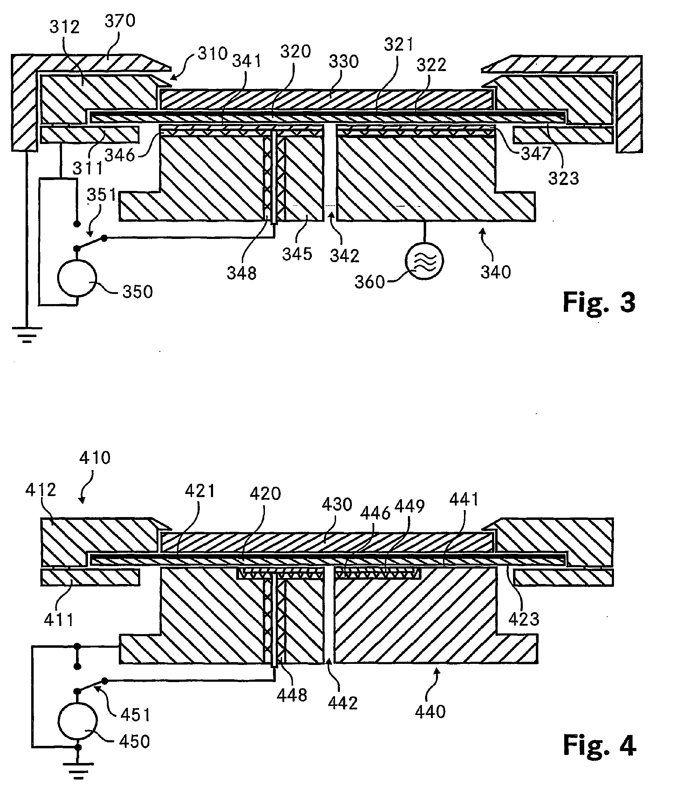

Die Figur 3 ist eine schematische Darstellung einer unipolaren Elektrode und eines Halte- und Transportrahmens einer dritten Ausführung einer erfindungsgemässen Bearbeitungsstation, welche eine Hochfrequenzquelle umfasst. Eine derartige Ausführung lässt sich beispielsweise in einer Bearbeitungsstation zum Ätzen des Substrats einsetzen. Der Aufbau und die Anordnung des Rahmens 310 ist identisch mit dem Rahmen der ersten Ausführungsform, wie sie in der Figur 1 dargestellt ist. Im Rahmen 310 ist eine Trägerfolie 320 aus Polyimid mit einer Dicke von 100 $\mu$m eingespannt, auf welcher das Substrat 330 grossflächig befestigt ist. Der Rahmen 310 ist aus einem ringförmigen Unterteil 311 und einem damit lösbar verbundenen entsprechenden ringförmigen Oberteil 312 zusammengesetzt, zwischen welchen die Trägerfolie 320 eingespannt ist. Sowohl der Unterteil 311 als auch der Oberteil 312 des Rahmens 310 sind aus einem leitfähigen Metall hergestellt. Eine Metallisierung 322 mit einer Dicke von 0.1 μm ist wiederum entlang ihrer oberen Hauptfläche 321 aufgedampft und wird vom Oberteil 312 des Rahmens elektrisch kontaktiert.

Die Elektrode 340 weist einen Grundkörper auf, welcher durch eine Hochfrequenz-Elektrode 345 gebildet wird, die durch eine Hochfrequenz-Spannungsquelle 360 gespiesen wird. Die Hochfrequenz-Elektrode 345 ist auf ihrer oberen Seite durch eine Keramik-Isolatorplatte 346 abgeschlossen, deren Fläche dem Querschnitt der Hochfrequenz-Elektrode 345 entspricht. Auf der Isolatorplatte 346 ist die Chuck-Elektrode 347 angeordnet, wiederum mit derselben Oberfläche. Durch die Hochfrequenz-Elektrode 345, die Isolatorplatte 346 und die Chuck-Elektrode 347 verläuft wiederum eine Gaszuführung 342. Der Rahmen 340 ist so angeordnet, dass die untere Hauptfläche 323 der Trägerfolie 320 parallel und mit geringem Abstand zur oberen Aussenfläche 341 der Chuck-Elektrode 347 positioniert ist.

Zwischen der Chuck-Elektrode 347 und dem mit der leitenden Metallisierung 322 elektrisch verbundenen Rahmen 310 ist wiederum eine Spannungsquelle 350 eingeschaltet, welche eine Gleichspannung zwischen der Metallisierung 322 und der oberen Aussenfläche 341 der Chuck-Elektrode 347 erzeugt. Dabei befindet sich die Metallisierung 322 aber im Gegensatz zur ersten Ausführungsform nicht auf Erdpotential, sondern der Chuck-Stromkreis ist floatend und weder mit dem Hochfrequenz-Kreis noch mit dem Erdpotential verbunden. Die Kontaktierung der Chuck-Elektrode 347 erfolgt durch eine isolierte Durchführung 348, welche durch die Hochfrequenz-Elektrode 345 und die Isolatorplatte 346 hindurch erfolgt.

Eine mit dem Erdpotential verbundene, ringförmige Abschirmung 370, deren Querschnitt ungefähr dem Rahmen 310 entspricht, ist oberhalb des Rahmens 310 angeordnet. Diese schafft bezüglich der beim Ätzvorgang eingesetzten Sputter-Quelle einen Dunkelraum zum Rahmen 310. Dadurch wird verhindert, dass Material des Rahmens 310 weggeätzt wird oder dass sich vom Substrat 330 weggeätztes Material auf dem Rahmen 310 ablagert.

Durch einen Schalter 351 kann der Rahmen 310 wiederum mit der Aussenfläche 341 kurzgeschlossen werden, so dass beide Bauteile auf dasselbe Potential gebracht werden. Danach lässt sich die Trägerfolie 320 mit dem Substrat 330 ungehindert von der Chuck-Elektrode 347 lösen.

Die Figur 4 ist eine schematische Darstellung einer bipolaren Elektrode und eines Halte- und Transportrahmens einer vierten Ausführung einer erfindungsgemässen Bearbeitungsstation.

Der mechanische Aufbau und die Anordnung des Rahmens 410 ist identisch mit dem Rahmen der ersten und dritten Ausführungsform, wie sie in den Figuren 1 und 3 dargestellt sind. Im Rahmen 410 ist wiederum die Trägerfolie 420 aus Polyimid mit einer Dicke von 100 μm eingespannt, auf welcher das Substrat 430 grossflächig befestigt ist. Der Rahmen 410 ist aus einem ringförmigen Unterteil 411 und einem damit lösbar verbundenen entsprechenden ringförmigen Oberteil 412 zusammengesetzt, zwischen welchen die Trägerfolie 420 eingespannt ist.

Der Rahmen 410 mit der eingespannten Trägerfolie 420 ist angrenzend an eine ebene obere Aussenfläche 441 einer metallischen Elektrode 440 angeordnet, wobei die untere Hauptfläche 423 der Trägerfolie 420 parallel und mit geringem Abstand zur oberen Aussenfläche 441 der Elektrode 440 positioniert ist. Die Fläche und Form der oberen Aussenfläche 441 der Elektrode 440 entspricht im Wesentlichen der Form und Fläche des auf die Trägerfolie 420 aufgeklebten Substrats 430.

In einem zentralen Bereich der oberen Aussenfläche 441 der Elektrode 440 ist eine zweite Elektrode 449 eingelassen, deren obere Fläche mit der oberen Aussenfläche 441 der Elektrode 440 fluchtet. Die zweite Elektrode 449 ist durch eine Keramik-Isolatorplatte 446 von der Elektrode 440 elektrisch isoliert. Die zweite Elektrode 449 weist etwa den halben Durchmesser der Elektrode 440 auf.

Die Elektrode 440 weist im Bereich ihrer Symmetrieachse wiederum eine Gaszuführung 442 auf, welche im Weiteren durch die Isolatorplatte 446 und die zweite Elektrode 449 verläuft und durch welche ein Rückseitengas dem zwischen der Trägerfolie 420 und der Aussenfläche 441 der Elektrode 440 liegenden Zwischenraum zugeführt werden kann.

Zwischen der metallischen Elektrode 440 und der zweiten Elektrode 449 ist eine Spannungsquelle 450 eingeschaltet, welche eine Gleichspannung zwischen den beiden Elektroden 440, 449 erzeugt. Die Kontaktierung der zweiten Elektrode 449 erfolgt dabei mittels einer isolierten Durchführung 448, welche durch die Elektrode 440 und die Isolatorplatte 446 hindurch führt. Die Elektrode 440 befindet sich dabei auf Erdpotential, während die zweite Elektrode 449 auf einem Potential von 700 V gehalten wird. Dadurch ergibt sich ein elektrisches Streufeld durch welches in der Metallisierung entlang der oberen Hauptfläche 421 der Folie 420 sowie gegebenenfalls im Substrat 420 elektrische Influenzladungen erzeugt werden. Aufgrund dieser Influenzladungen, deren Polarität der jeweils angrenzenden Elektrode entgegengesetzt ist, ergibt sich eine anziehende Kraft, durch welche die Folie 420 mit dem aufgeklebten Substrat 430 an die Elektrode 440 gedrückt wird. Durch die dargestellte Ausführung wird also das Prinzip einer bipolaren elektrostatischen Aufspannvorrichtung (Chuck) im Rahmen der Erfindung verwirklicht. Eine elektrische Kontaktierung der auf der Folie 420 aufgedampften Metallisierung oder des Substrats 430 ist nicht notwendig.

Durch einen Schalter 451 können die Elektroden 440, 449 miteinander kurzgeschlossen werden, so dass beide Bauteile auf Erdpotential gebracht werden. Danach lässt sich die Trägerfolie 420 mit dem Substrat 430 ungehindert von der Elektrode 440 lösen.

Die Anordnung der einzelnen Elektroden an der oberen Aussenfläche der Elektrode ist nicht auf die dargestellte Ringform beschränkt. Die zwei Pole können auch auf andere Weise entlang der Oberfläche verteilt sein, beispielsweise kann die innere Elektrode sternförmig ausgebildet sein. Im Weiteren können auf eine ähnliche Weise multipolare Elektroden mit mehr als zwei Unterelektroden ausgeführt werden. Als Beispiel ist eine Anordnung möglich, bei welcher die kreisförmige Aussenfläche wie im dargestellten Beispiel ringförmig aufgeteilt und zusätzlich noch halbiert wird, so dass vier Bereiche gebildet werden. Aneinander angrenzende Bereiche werden dann so mit der Stromquelle verbunden, dass sie jeweils eine unterschiedliche Polarität aufweisen.

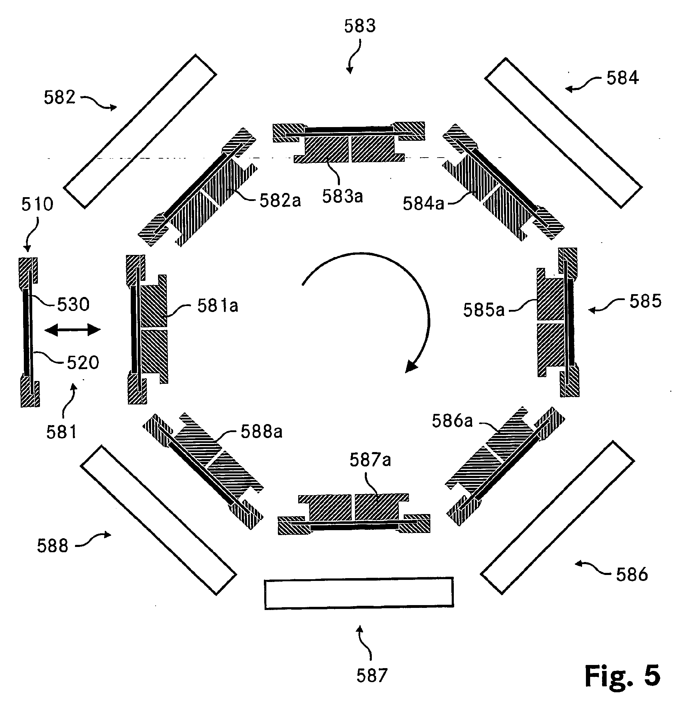

Die Figur 5 ist eine schematische Darstellung einer Vakuumprozessanlage mit einer Mehrzahl von Bearbeitungsstationen. Die acht Bearbeitungsstationen 581...588 bilden in ihrer Anordnung ein regelmässiges Achteck. Alle Bearbeitungsstationen weisen auf der Innenseite eine Elektrode 581 a...588a gemäss einer der vier beschriebenen Ausführungsformen auf, wobei in derselben Anlage auch unterschiedliche Elektroden (z. B. uni- und bipolare oder solche mit einer Hochfrequenz-Quelle) eingesetzt werden können. Die oberen Aussenflächen der Elektroden 581a...588a stehen vertikal und sind nach aussen orientiert.

Ein Substrat 530, welches auf eine in einem Rahmen 510 eingespannte Trägerfolie 520 aufgeklebt worden ist, wird bei einer Transferstation 581 in die Anlage eingeführt und nach der Bearbeitung wieder aus ihr entnommen. Die Transferstation 581 umfasst beispielsweise eine Vakuumschleuse. Der Rahmen 510 bleibt während der gesamten Verarbeitung vertikal orientiert. Nachdem der Rahmen 510 mit dem Substrat 530 an die Elektrode 581 a herangeführt worden ist, wird gemäss einer der vier dargestellten Ausführungsformen eine Spannung an die Elektrode (und gegebenenfalls den Rahmen) angelegt, so dass der Rahmen an der Elektrode 581 a festgehalten wird. Es erfolgt nun die Aufnahme des Rahmens in eine (nicht dargestellte) sternförmige Transportvorrichtung, durch welche simultan acht je in einer Bearbeitungsstation positionierte Rahmen im Uhrzeigersinn in die angrenzende Bearbeitungsstation transportiert werden können.

Nach dem Transport erfolgt der erste Bearbeitungsschritt in der Entgasungsstation 582, wo der Rahmen 510, wie in allen Bearbeitungsstationen 581...588, während des Bearbeitungsvorgangs an der Elektrode 582a festgehalten wird. Daran schliesst sich eine Kühlstation 583 an. Weil bei der erfindungsgemässen Haltevorrichtung kein Plasma zur elektrischen Kontaktierung des Substrats notwendig ist, kann die Kühlung des auf der Elektrode 583a gehaltenen Substrats auf einfache Weise erfolgen. Als nächstes schliesst sich eine Ätzstation 584 an, auf welche wiederum eine Kühlstation 585 folgt. Schliesslich folgen nacheinander drei Sputterstationen 586, 587, 588, worauf das bearbeitete Substrat 530 bei der Transportstation 581 wieder aus der Anlage entnommen werden kann.

Die angegebenen Dimensionen der Vorrichtungen sind lediglich als Beispiele zu verstehen. Sie können den elektrischen und mechanischen Anforderungen angepasst werden. Dies gilt namentlich für die Ausdehnung und die Dicke der Elektrode und ihrer Bestandteile, des Rahmens und der darin eingespannten Folie. Auch die Materialien können aufgrund des beabsichtigten Verwendungszwecks unterschiedlich ausgewählt werden. Beispielsweise kann eine Folie aus einem anderen Kunststoff als Polyimid oder anstelle einer Folie ein Plättchen aus einer Keramik, aus Glas oder aus einem anderen dielektrischen Material als Träger für das Substrat in den Rahmen eingespannt werden.

Die angegebene Spannung der Gleichstromquelle kann dem Anwendungsgebiet und der Dimensionierung der Elektrode und des Dielektrikums angepasst werden, so dass sich ein Rückseitengasdruck erreichen lässt, welcher eine ausreichende Kühlung des Substrats ermöglicht.

Wesentliche Einflussmöglichkeiten ergeben sich durch die Anpassung des Materials des Dielektrikums (der Folie in der ersten, dritten und vierten Ausführung oder der dielektrischen Platte in der zweiten Ausführung). Wird anstelle eines nicht-leitenden dielektrischen Materials ein schwach dotiertes dielektrisches Material eingesetzt, ergibt sich ein "halbleitendes Dielektrikum". Bei diesem verschiebt sich die Ladung von der Oberfläche der Elektrode in das Dielektrikum hinein, so dass sich ein geringerer effektiver Abstand der beiden sich anziehenden "Platten" ergibt, was gegenüber einem elektrisch isolierenden Dielektrikum zu einer bedeutend höheren Anpresskraft bei gleicher Spannung führt. Anstelle einer Coulomb-Anziehung ergibt sich eine sog. Johnsen-Rahbek-Anziehung. Nachteilig bei einem solchen dotierten Dielektrikum gegenüber einem nicht-leitenden Dielektrikum kann sein, dass die halbleitende Wirkung oft erst bei höheren Temperaturen auftritt, welche bei der erfindungsgemässen Anlage gerade vermieden werden sollen. Ausserdem muss zusätzlich ein gewisser kontinuierlicher Ladestrom bereitgestellt werden, damit die Anziehung aufrechterhalten bleibt.

Die dargestellte Vakuumprozessanlage ist nur ein Beispiel. Es kann eine grössere oder kleinere Zahl von Bearbeitungsstationen ringförmig angeordnet werden, oder die Bearbeitungsstationen können linear hintereinander positioniert werden. Mit der erfindungsgemässen Vorrichtung können auch Anlagen bestückt werden, in denen die Substrate auf horizontal angeordneten Trägern transportiert werden, z. B. in der vorbekannten Form eines Clusters mit zentraler Handlingstation.

Zusammenfassend ist festzustellen, dass die Erfindung eine Anlage zur Bearbeitung eines Substrats schafft, welche einen einfachen Aufbau aufweist, einfach gewartet werden kann, und in welcher ein dünnes und/oder grossflächiges, mechanisch empfindliches Substrat ohne Gefahr der Beschädigung oder Zerstörung bearbeitet werden kann.

**EP 1 604 384 B1**

**Patentansprüche**

1. Anlage, insbesondere Vakuumprozessanlage, zur Bearbeitung eines Substrats (130; 230; 330; 430; 530), insbesondere eines Halbleiterwafers, mit mindestens einer Bearbeitungsstation (582-588), wobei die mindestens eine Bearbeitungsstation (582-588) eine Aufspannelektrode (140; 240; 340; 440) umfasst, mit einer ebenen Aussenfläche (141; 244; 341; 441), wobei das Substrat (130; 230; 330; 430; 530) ganzflächig auf dem Träger (120; 220; 320; 420; 520) befestigbar ist, wobei der Träger (120; 220; 320) aus einem nicht-leitenden dielektrischen Material besteht und einseitig mit einer leitfähigen Schicht (122; 222; 322) versehen ist, **dadurch gekennzeichnet, dass** die Anlage zum Halten und/oder Transportieren des Substrats (130; 230; 330; 430; 530) mindestens einen Rahmen (110; 210; 310; 410; 510) mit einem eingespannten Träger (120; 220; 320; 420; 520) umfasst, und wobei der Träger (120; 220; 320; 420; 520) parallel und angrenzend an die Aussenfläche (141; 244; 341; 441) der Aufspannelektrode (140; 240; 340; 440) positionierbar ist, so dass die leitfähige Schicht des Trägers zusammen mit dem dielektrischen Material und der Aufspannelektrode eine elektrostatische Aufspannvorrichtung bildet.

2. Anlage nach Anspruch 1, **dadurch gekennzeichnet, dass** der Rahmen (110; 210; 310) zumindest in einem Bereich leitfähig ist und dass der Träger (120; 220; 320) so im Rahmen (110; 210; 310) eingespannt ist, dass die leitfähige Schicht (122; 222; 322) des Trägers (120; 220; 320) den leitfähigen Bereich des Rahmens (110; 210; 310) kontaktiert.

3. Anlage nach Anspruch 2, **dadurch gekennzeichnet, dass** der Träger (120; 220; 320) durch eine vakuumtaugliche, temperaturbeständige Folie, insbesondere aus Polyimid, und die leitfähige Schicht (122; 222; 322) durch eine aufgedampfte Metallisierung oder ein leitfähiges Polymer gebildet sind.

4. Anlage nach Anspruch 3, **dadurch gekennzeichnet, dass** die Folie (120; 220; 320) eine Dicke von 50-200 $\mu$m, vorzugsweise ungefähr 100 $\mu$m, und die Metallisierung (122; 222; 322) eine Dicke von 0.03-0.5 $\mu$m, vorzugsweise ungefähr 0.1 $\mu$m, haben.

5. Anlage nach einem der Ansprüche 1 bis 4, **dadurch gekennzeichnet, dass** die Aufspannelektrode (347) auf einem Grundkörper aufgebaut ist, welcher eine Hochfrequenz-Elektrode (345) umfasst, wobei die Aufspannelektrode (347) von der Hochfrequenz-Elektrode (345) elektrisch isoliert ist, wobei insbesondere eine isolierte Durchführung (348) durch die Hochfrequenz-Elektrode (345) zum Kontaktieren der Aufspannelektrode (340) vorgesehen ist.

6. Anlage nach einem der Ansprüche 1 bis 5, **dadurch gekennzeichnet, dass** die Aufspannelektrode (240) ein Dielektrikum (243), insbesondere eine Platte aus Aluminiumoxid $Al_2O_3$, umfasst, welches so angeordnet ist, dass es zwischen der Aufspannelektrode (240) und dem Träger (220) liegt, wenn der Träger (220) parallel und angrenzend an die Aussenfläche (244) der Aufspannelektrode (240) positioniert ist.

7. Anlage nach einem der Ansprüche 2 bis 6, **dadurch gekennzeichnet, dass** die Bearbeitungsstation (582-588) eine Spannungsquelle (150; 250; 350) umfasst zum Anlegen einer Spannung zwischen dem Rahmen (110; 210; 310) und der Aufspannelektrode (140; 240; 340), wobei insbesondere eine Gleichspannung von 200-1500 V, bevorzugt 500-1000 V, erzeugbar ist.

8. Anlage nach einem der Ansprüche 1 bis 7, **dadurch gekennzeichnet, dass** die Aufspannelektrode (440) mehrere Bereiche unterschiedlicher Polarität umfasst.

9. Anlage nach einem der Ansprüche 1 bis 8, **dadurch gekennzeichnet, dass** die Bearbeitungsstation (582-588) eine Gaszuführung (142; 242; 342; 442) umfasst zum Zuführen eines Gases in einen Zwischenraum zwischen der Aufspannelektrode (140; 240; 340; 440) und dem Träger (120; 220; 320; 420), wobei bevorzugt ein Gasdruck von mehr als 100 Pa erzeugbar ist.

10. Rahmen für eine Anlage nach einem der Ansprüche 1. bis 9 zum Halten und/oder Transportieren des Substrats (130; 230; 330; 430), **dadurch gekennzeichnet, dass** er zum Einspannen eines Trägers (120; 220; 320; 420), insbesondere einer Folie, ausgebildet ist und dass er zumindest in einem Bereich leitfähig ist, derart dass durch den leitfähigen Bereich eine leitfähige Schicht (122; 222; 322) des eingespannten Trägers (120; 220; 320) kontaktiert werden kann.

11. Verfahren zum Bearbeiten eines Substrats (130; 230; 330; 430), insbesondere eines Halbleiterwafers, in einer Vakuumprozessanlage, **dadurch gekennzeichnet, dass**

a) das Substrat (130; 230; 330; 430) zum Halten und/oder Transportieren auf einem in einem Rahmen (110; 210; 310; 410) eingespannten Träger (120; 220; 320; 420) ganzflächig befestigt wird, wobei der Träger aus einem nicht-leitenden dielektrischen Material besteht und einseitig mit einer leitfähigen Schicht (122; 222; 322) versehen ist; und

b) wobei der Träger (120; 220; 320; 420; 520) parallel und angrenzend an eine ebene Aussenfläche (141; 244; 341; 441) einer Aufspannelektrode (140; 240; 340; 440) angeordnet wird, so dass die leitfähige Schicht des Trägers zusammen mit dem dielektrischen Material und der Aufspannelektrode eine elektrostatische Aufspannvorrichtung bildet.

**12.** Verfahren nach Anspruch 11, **dadurch gekennzeichnet, dass** das Substrat (130; 230; 330; 430) mittels eines vakuumtauglichen und lösbaren Klebers auf eine erste ebene Hauptfläche (121; 221; 321; 421) des Trägers (120; 220; 320; 420) aufgeklebt wird.

**13.** Verfahren nach Anspruch 12, **dadurch gekennzeichnet, dass** die Aufspannelektrode (140; 240; 340; 440) mit ihrer Aussenfläche (141; 244; 341; 441) parallel und angrenzend an eine zweite ebene Hauptfläche (123; 223; 323; 423) des Trägers (120; 220; 320; 420) angeordnet wird, wobei die zweite ebene Hauptfläche (123; 223; 323; 423) der ersten ebenen Hauptfläche (121; 221; 321; 421) gegenüberliegt.

**14.** Verfahren nach Anspruch 13, **dadurch gekennzeichnet, dass** die erste Hauptfläche (121; 321; 421) des Trägers (120; 320; 420) mit einer leitfähigen Schicht (122; 322; 422) versehen ist.

**15.** Verfahren nach Anspruch 14, **dadurch gekennzeichnet, dass** die Aufspannelektrode (347) auf einem Grundkörper aufgebaut ist, welcher durch eine Hochfrequenz-Elektrode (345) gebildet ist, wobei die Aufspannelektrode (347) von der Hochfrequenz-Elektrode (345) elektrisch isoliert ist und die Spannung zwischen der Aufspannelektrode (347) und dem Rahmen (310) insbesondere mittels einer isolierten Durchführung (348) angelegt wird.

**16.** Verfahren nach Anspruch 13, **dadurch gekennzeichnet, dass** die zweite Hauptfläche (223) des Trägers (220) mit einer leitfähigen Schicht (222) versehen ist und dass zwischen der Aufspannelektrode (240) und der zweiten ebenen Hauptfläche (223) des Trägers (220), ein Dielektrikum (243) angeordnet wird.

**17.** Verfahren nach einem der Ansprüche 11 bis 16, **dadurch gekennzeichnet, dass** eine Spannung zwischen dem Rahmen (110; 210; 310) und der Aufspannelektrode (140; 240; 340) angelegt wird.

**18.** Verfahren nach einem der Ansprüche 11 bis 17, **dadurch gekennzeichnet, dass** zum Temperieren des Substrats (130; 230; 330; 430) ein Gas mit einem Überdruck in einen Zwischenraum zwischen dem Träger (120; 220; 320; 420) und der ebenen Aussenfläche (141; 244; 341; 441) der Aufspannelektrode (140; 240; 340; 440) eingeleitet wird.

**19.** Verfahren nach einem der Ansprüche 11 bis 18, **dadurch gekennzeichnet, dass** zum Ablösen des Substrats (130; 230; 330) die leitfähige Schicht (122; 222; 322) des Trägers (120; 220; 320) mit der Aufspannelektrode (140; 240; 340) kurzgeschlossen wird.

**Claims**

**1.** Installation, in particular a vacuum process installation, for processing a substrate (130; 230; 330; 430; 530), in particular a semiconductor wafer, with at least one processing station (582-588), the at least one processing station (582-588) comprising a chuck electrode (140; 240; 340; 440), with a flat outer surface (141; 244; 341; 441), the substrate (130; 230; 330; 430; 530) being able to be secured over its full surface area on a carrier (120; 220; 320; 420; 520), the carrier (120; 220; 320) consisting of a non-conducting dielectric material and being provided with a conductive layer (122; 222; 322) on one side, **characterized in that**, for holding and/or transporting the substrate (130; 230; 330; 430; 530), the installation comprises at least one frame (110; 210; 310; 410; 510) with the carrier (120; 220; 320; 420; 520) clamped in it, and the carrier (120; 220; 320; 420; 520) can be positioned parallel and adjacent to the outer surface (141; 244; 341; 441) of the chuck electrode (140; 240; 340; 440), so that the conductive layer of the carrier together with the dielectric material and the chuck electrode form an electrostatic chuck.

**2.** Installation according to Claim 1, **characterized in that** at least one region of the frame (110; 210; 310) is conductive and **in that** the carrier (120; 220; 320) is clamped in the frame (110; 210; 310) in such a way that the conductive layer (122; 222; 322) of the carrier (120; 220; 320) electrically contacts the conductive region of the frame (110;

210; 310).

3. Installation according to Claim 2, **characterized in that** the carrier (120; 220; 320) is formed by a vacuum-compatible, thermally stable film, in particular of polyimide, and the conductive layer (122; 222; 322) is formed by a vapour-deposited metallization or a conductive polymer.

4. Installation according to Claim 3, **characterized in that** the film (120; 220; 320) has a thickness of 50-200 $\mu$m, preferably approximately 100 $\mu$m, and the metallization (122; 222; 322) has a thickness of 0.03-0.5 $\mu$m, preferably approximately 0.1 $\mu$m.

5. Installation according to one of Claims 1 to 4, **characterized in that** the chuck electrode (347) is constructed on a base body which comprises a radiofrequency electrode (345), the chuck electrode (347) being electrically insulated from the radiofrequency electrode (345), with in particular an insulated leadthrough (348) through the radiofrequency electrode (345) being provided for electrically contacting the chuck electrode (340).

6. Installation according to one of Claims 1 to 5, **characterized in that** the chuck electrode (240) comprises a dielectric (243), in particular a plate of aluminium oxide $Al_2O_3$, which is arranged in such a way that it lies between the chuck electrode (240) and the carrier (220) when the carrier (220) has been positioned parallel and adjacent to the outer surface (244) of the chuck electrode (240).

7. Installation according to one of Claims 2 to 6, **characterized in that** the processing station (582-588) comprises a voltage source (150; 250; 350) for applying a voltage between the frame (110; 210; 310) and the chuck electrode (140; 240; 340), it being possible in particular to generate a DC voltage of 200-1500 V, preferably 500-1000 V.

8. Installation according to one of Claims 1 to 7, **characterized in that** the chuck electrode (440) comprises a number of regions of different polarity.

9. Installation according to one of Claims 1 to 8, **characterized in that** the processing station (582-588) comprises a gas feed (142; 242; 342; 442) for feeding a gas into an intermediate space between the chuck electrode (140; 240; 340; 440) and the carrier (120; 220; 320; 420), it preferably being possible to generate a gas pressure of more than 100 Pa.

10. Frame for the installation according to one of Claims 1 to 9 for holding and/or transporting the substrate (130; 230; 330; 430), **characterized in that** it is designed for clamping in a carrier (120; 220; 320; 420), in particular a film, and **in that** it is conductive at least in one region in such a way that a conductive layer (122; 222; 322) of the clamped-in carrier (120; 220; 320) can be electrically contacted through the conductive region.

11. Method for processing a substrate (130; 230; 330; 430), in particular a semiconductor wafer, in a vacuum process installation, **characterized in that**

a) in order to be held and/or transported, the substrate (130; 230; 330; 430) is secured over its full surface area on a carrier (120; 220; 320; 420) clamped in a frame (110; 210; 310; 410), the carrier consisting of a non-conducting dielectric material and being provided with a conductive layer (122; 222; 322) on one side; and
b) the carrier (120; 220; 320; 420; 520) is arranged parallel and adjacent to a flat outer surface (141; 244; 341; 441) of a chuck electrode (140; 240; 340; 440), so that the conductive layer of the carrier together with the dielectric material and the chuck electrode form an electrostatic chuck.

12. Method according to Claim 11, **characterized in that** the substrate (130; 230; 330; 430) is adhesively bonded onto a first flat main surface (121; 221; 321; 421) of the carrier (120; 220; 320; 420) by means of a vacuum-compatible and releasable adhesive.

13. Method according to Claim 12, **characterized in that** the chuck electrode (140; 240; 340; 440) is arranged with its outer surface (141; 244; 341; 441) parallel and adjacent to a second flat main surface (123; 223; 323; 423) of the carrier (120; 220; 320; 420), the second flat main surface (123; 223; 323; 423) being on the opposite side from the first flat main surface (121; 221; 321; 421).

14. Method according to Claim 13, **characterized in that** the first main surface (121; 321; 421) of the carrier (120; 320; 420) is provided with a conductive layer (122; 322; 422).

**15.** Method according to Claim 14, **characterized in that** the chuck electrode (347) is constructed on a base body which is formed by a radiofrequency electrode (345), the chuck electrode (347) being electrically insulated from the radiofrequency electrode (345) and the voltage between the chuck electrode (347) and the frame (310) being applied in particular by means of an insulated leadthrough (348).

**16.** Method according to Claim 13, **characterized in that** the second main surface (223) of the carrier (220) is provided with a conductive layer (222) and **in that** a dielectric (243) is arranged between the chuck electrode (240) and the second flat main surface (223) of the carrier (220).

**17.** Method according to one of Claims 11 to 16, **characterized in that** a voltage is applied between the frame (110; 210; 310) and the chuck electrode (140; 240; 340).

**18.** Method according to one of Claims 11 to 17, **characterized in that**, to control the temperature of the substrate (130; 230; 330; 430), a gas at a superatmospheric pressure is introduced into an intermediate space between the carrier (120; 220; 320; 420) and the flat outer surface (141; 244; 341; 441) of the chuck electrode (140; 240; 340; 440).

**19.** Method according to one of Claims 11 to 18, **characterized in that**, to release the substrate (130; 230; 330), the conductive layer (122; 222; 322) of the carrier (120; 220; 320) is shortcircuited with the chuck electrode (140; 240; 340).

## Revendications

**1.** Installation, en particulier installation de traitement sous vide, destinée au traitement d'un substrat (130; 230; 330; 430; 530), en particulier d'une galette semi-conductrice, et qui présente au moins un poste de traitement (582-588), le ou les postes de traitement (582-588) comprenant une électrode de fixation (140; 240; 340; 440) dotée d'une surface extérieure plane (141; 244; 341; 441),
le substrat (130; 230; 330; 430; 530) pouvant être fixé par toute la surface sur le support (120; 220; 320; 420; 520), le support (120; 220; 320) étant constitué d'un matériau diélectrique non conducteur et étant doté sur une face d'une couche conductrice (122; 222; 322),
**caractérisée en ce que**
pour maintenir et/ou transporter le substrat (130; 230; 330; 430; 530), l'installation comprend au moins un cadre (110; 210; 310; 410; 510) dans lequel est serré un support (120; 220; 320; 420; 520) et
**en ce que** le support (120; 220; 320; 420; 520) peut être placé parallèlement et en position adjacente à la surface extérieure (141; 244; 341; 441) de l'électrode de serrage (140; 240; 340; 440) de telle sorte que la couche conductrice du support forme un dispositif électrostatique de serrage avec le matériau diélectrique et l'électrode de serrage.

**2.** Installation selon la revendication 1, **caractérisée en ce que** le cadre (110; 210; 310) est conducteur au moins dans une partie et **en ce que** le support (120; 220; 320) est serré dans le cadre (110; 210; 310) de telle sorte que la couche conductrice (122; 222; 322) du support (120; 220; 320) soit en contact avec la partie conductrice du cadre (110; 210; 310).

**3.** Installation selon la revendication 2, **caractérisée en ce que** le support (120; 220; 320) est formé d'un film résistant à la dépression et à la température, en particulier en polyimide, et la couche conductrice (122; 222; 322) d'une métallisation déposée par vaporisation ou d'un polymère conducteur.

**4.** Installation selon la revendication 3, **caractérisée en ce que** le film (120; 220; 320) présente une épaisseur de 50 à 200 $\mu$m et de préférence d'environ 100 $\mu$m et la métallisation (122; 222; 322) présente une épaisseur de 0,03 à 0,5 $\mu$m et de préférence d'environ 0,1 $\mu$m.

**5.** Installation selon l'une des revendications 1 à 4, **caractérisée en ce que** l'électrode de serrage (347) est constituée d'un corps de base qui comporte une électrode (345) à haute fréquence, l'électrode de serrage (347) étant isolée électriquement de l'électrode (345) à haute fréquence, un passage isolé (348) étant prévu en particulier à travers l'électrode (345) à haute fréquence pour permettre le contact avec l'électrode de serrage (340).

**6.** Installation selon l'une des revendications 1 à 5, **caractérisée en ce que** l'électrode de serrage (240) comprend un diélectrique (243), en particulier une plaque en oxyde d'aluminium $Al_2O_3$, qui est disposée de telle sorte qu'il repose entre l'électrode de serrage (240) et le support (220) lorsque le support (220) est placé parallèlement et en position adjacente à la surface extérieure (244) de l'électrode de serrage (240).

7.  Installation selon l'une des revendications 2 à 6, **caractérisée en ce que** le poste de traitement (582-588) comprend une source de tension (150; 250; 350) qui permet d'appliquer une tension entre le cadre (110; 210; 310) et l'électrode de serrage (140; 240; 340), et permet d'appliquer en particulier une tension continue de 200 à 1 500 V et de préférence de 500 à 1 000 V.

8.  Installation selon l'une des revendications 1 à 7, **caractérisée en ce que** l'électrode de serrage (440) comporte plusieurs zones de polarités différentes.

9.  Installation selon l'une des revendications 1 à 8, **caractérisée en ce que** le poste de traitement (582-588) comprend une amenée de gaz (142; 242; 342; 442) qui permet d'amener un gaz dans l'espace intermédiaire entre l'électrode de serrage (140; 240; 340; 440) et le support (120; 220; 320; 420), et permet de préférence de délivrer une pression de gaz supérieure à 100 Pa.

10. Cadre pour installation selon l'une des revendications 1 à 9, pour le maintien et/ou le transport du substrat (130; 230; 330; 430),
    **caractérisé en ce que**
    il est formé pour serrer un support (120; 220; 320; 420), en particulier un film, et
    **en ce qu'**il est conducteur dans au moins une partie, de telle sorte qu'une couche conductrice (122; 222; 322) du support serré (120; 220; 320) puisse être mise en contact par l'intermédiaire de la zone conductrice.

11. Procédé de traitement d'un substrat (130; 230; 330; 430), en particulier une galette semi-conductrice, dans une installation de traitement sous vide, **caractérisé en ce que**

    a) le substrat (130; 230; 330; 430) est fixé sur toute sa surface sur un support (120; 220; 320; 420) serré dans un cadre (110; 210; 310; 410) pour être maintenu et/ou transporté, le support étant constitué d'un matériau diélectrique non-conducteur et étant doté sur une face d'une couche conductrice (122; 222; 322) et **en ce que**
    b) le support (120; 220; 320; 420; 520) est disposé parallèlement et en position adjacente à une surface extérieure plane (141; 244; 341; 441) d'une électrode de serrage (140; 240; 340; 440), de telle sorte que la couche conductrice du support forme un dispositif électrostatique de serrage avec le matériau diélectrique et l'électrode de serrage.

12. Procédé selon la revendication 11, **caractérisé en ce que** le support (130; 230; 330; 430) est collé au moyen d'un adhésif résistant au vide et libérable sur une première surface principale plane (121; 221; 321; 421) du support (120; 220; 320; 420).

13. Procédé selon la revendication 12, **caractérisé en ce que** l'électrode de serrage (140; 240; 340; 440) est disposée avec sa surface extérieure (141; 244; 341; 441) parallèle et adjacente à une deuxième surface principale plane (123; 223; 323; 423) du support (120; 220; 320; 420), la deuxième surface principale plane (123; 223; 323; 423) étant située face à la première surface principale plane (121; 221; 321; 421).

14. Procédé selon la revendication 13, **caractérisé en ce que** la première surface principale (121; 321; 421) du support (120; 320; 420) est dotée d'une couche conductrice (122; 322; 422).

15. Procédé selon la revendication 14, **caractérisé en ce que** l'électrode de serrage (347) est montée sur un corps de base qui est formé par une électrode (345) à haute fréquence, l'électrode de serrage (347) étant isolée électriquement de l'électrode (345) à haute fréquence et la tension étant appliquée entre l'électrode de serrage (347) et le cadre (310) en particulier au moyen d'un passage (348) isolé.

16. Procédé selon la revendication 13, **caractérisé en ce que** la deuxième surface principale (223) du support (220) est doté d'une couche conductrice (222) et **en ce qu'**un diélectrique (243) est disposé entre l'électrode de serrage (240) et la deuxième surface principale plane (223) du support (220).

17. Procédé selon l'une des revendications 11 à 16, **caractérisé en ce qu'**une tension est appliquée entre le cadre (110; 210; 310) et l'électrode de serrage (140; 240; 340).

18. Procédé selon l'une des revendications 11 à 17, **caractérisé en ce que** pour maintenir la température du substrat (130; 230; 330; 430), un gaz est introduit avec une surpression dans l'espace intermédiaire situé entre le support (120; 220; 320; 420) et la surface extérieure plane (141; 244; 341; 441) de l'électrode de serrage (140; 240; 340; 440).

19. Procédé selon l'une des revendications 11 à 18, **caractérisé en ce que** pour détacher le substrat (130; 230; 330), la couche conductrice (122; 222; 322) du support (120; 220; 320) est mise en court-circuit avec l'électrode de serrage (140; 240; 340).

Fig. 1

Fig. 2

**Fig. 3**

**Fig. 4**

583

584

582

510

530

520

582a  583a  584a

581a

581

585a  585

586a

588a

587a

588

586

587

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4680061 A
- US 4743570 A, Varian
- US 6477787 B2
- US 5880924 A
- US 6547559 B
- US 5460684 A
- EP 0844659 A2
- US 6259592 B1
- US 5708557 A
- EP 0486966 A1
- US 20030012628 A1
- US 6238160 B1